(19) Europäisches Patentamt
European Patent Office
Office européen des brevets

(11) **EP 4 250 880 A1**

(12) **EUROPEAN PATENT APPLICATION**

(43) Date of publication:
**27.09.2023 Bulletin 2023/39**

(21) Application number: **23155088.0**

(22) Date of filing: **06.02.2023**

(51) International Patent Classification (IPC):
*H05K 3/38* (2006.01)   *H05K 3/00* (2006.01)
*H05K 3/18* (2006.01)   *H05K 3/16* (2006.01)

(52) Cooperative Patent Classification (CPC):
**H05K 3/387;** H05K 3/0032; H05K 3/16; H05K 3/181;
H05K 3/381; H05K 2203/0759; H05K 2203/095;
H05K 2203/107

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **22.03.2022   JP 2022046024**

(71) Applicant: **TOYOTA JIDOSHA KABUSHIKI
KAISHA
Aichi-Ken 471-8571 (JP)**

(72) Inventors:
• **YANAGIMOTO, Hiroshi**
  **Toyota-shi, 471-8571 (JP)**

• **KUNO, Oji**
  **Toyota-shi, 471-8571 (JP)**
• **MURAI, Jyunya**
  **Toyota-shi, 471-8571 (JP)**
• **KURODA, Keiji**
  **Toyota-shi, 471-8571 (JP)**
• **OKAZAKI, Tomoya**
  **Toyota-shi, 471-8571 (JP)**
• **MORI, Rentaro**
  **Toyota-shi, 471-8571 (JP)**

(74) Representative: **J A Kemp LLP
80 Turnmill Street
London EC1M 5QU (GB)**

(54) **METHOD FOR MANUFACTURING BOARD WITH ROUGHENED SURFACE AND METHOD FOR MANUFACTURING BOARD HAVING PLATED LAYER**

(57)   Provided is a method for manufacturing a board with a roughened surface and a method for manufacturing a board having a plated layer that allow easily manufacturing the board having a plated layer. One of embodiments is a method for manufacturing a board with a surface roughened for wiring formation. The method for manufacturing a board includes performing laser ablation on a board containing a resin at least on a surface of the board. A laser light irradiated in the laser ablation is a laser light having a pulse width of 1 ps or less, a wavelength of 320 nm or more, and an output of 1 W or less.

Fig. 1

EP 4 250 880 A1

**Description**

Technical Field

The present disclosure relates to a method for manufacturing a board with a roughened surface and a method for manufacturing a board having a plated layer.

Background Art

A large capacity and simultaneous connection are required for a mobile communication system, and in order to fulfill these performances, a high-density micro wiring board is desired.

For example, Patent Literature 1 (JP 2021-55174 A) discloses a method for modifying a surface of a resin molding and forming a metal film. The method includes a first step of irradiating a resin molding surface layer with a laser beam with a wavelength of 194 nm to 1064 nm at a low output to vaporize a vulnerable layer on the molding surface and moisture contained in the vulnerable layer by light energy, which inhibit adhesive bonding between the resin molding and an electroless plating film, a second step of causing a molecular bonding agent to adhere to the molding surface layer by applying the molecular bonding agent for the adhesive bonding of a plating film to be formed at a later step to the laser-irradiated resin molding, and subsequently exposing it to UV light having a wavelength of 185 nm to 365 nm, a third step of supporting a metal catalyst that becomes an electroless plating catalyst on the molecular bonding agent that adheres to the molding surface layer, and a fourth step of forming an electroless plated layer on the resin molding.

Citation List

Patent Literature

Patent Literature 1: JP 2021-55174 A

Summary of Invention

Technical Problem

For example, the invention disclosed in Patent Literature 1 (JP 2021-55174 A) specifies vaporizing low molecular weight components and moisture that remain in the resin molding surface layer, applying the molecular bonding agent to the resin molding surface layer and providing the electroless plated layer after the molecular bonding agent adheres, and the like. If a board having a plated layer is manufactured by the invention disclosed in JP 2021-55174 A, an extremely complicated process would be required.

Therefore, the present disclosure provides a method for manufacturing a board with a roughened surface and a method for manufacturing a board having a plated layer that allow easily manufacturing the board having a plated layer.

Solution to Problem

The inventors have intensively studied to solve the above-described problem and found that a board having a plated layer can be easily manufactured from a board acquired by performing laser ablation under specific conditions. Thus, the present disclosure has been completed.

Exemplary aspects of the embodiment are described as follows.

(1) A method for manufacturing a board with a surface roughened for wiring formation, the method for manufacturing a board comprising performing laser ablation on a board containing a resin at least on a surface of the board, wherein a laser light irradiated in the laser ablation is a laser light having a pulse width of 1 ps or less, a wavelength of 320 nm or more, and an output of 1 W or less.

(2) The method for manufacturing a board according to (1), wherein the laser light is a laser light having a pulse width of 0.1 ps or more.

(3) The method for manufacturing a board according to (1) or (2), wherein the laser light is a laser light having a wavelength of 1064 nm or less.

(4) The method for manufacturing a board according to any one of (1) to (3), wherein the laser light is a laser light having an output of 0.05 W or more.

(5) A board comprising: a resin at least on a surface of the board, wherein the surface has an arithmetic mean height Sa of 50 to 200 nm and a functional group amount (area ratio) in a C1s spectrum obtained from an XPS spectrum of 10% or more.

(6) A method for manufacturing a board having a plated layer, comprising: forming an electroless plated layer by performing electroless plating on a surface of a board acquired by the method for manufacturing a board according to any one of (1) to (4) or the board according to (5); forming an electrolytic plated layer by performing electrolytic plating on the electroless plated layer; and performing an annealing treatment on the board on which the electrolytic plated layer is formed.

(7) A method for manufacturing a board having a plated layer, comprising: forming a dry plated layer by performing dry plating on a surface of a board acquired by the method for manufacturing a board according to any one of (1) to (4) or the board according to (5); forming an electrolytic plated layer by performing electrolytic plating on the dry plated layer; and performing an annealing treatment on the board on which the electrolytic plated layer is formed.

(8) The method for manufacturing a board having a plated layer according to (7), comprising, before the forming of the dry plated layer, performing a plasma treatment on a surface of a board acquired by the method for manufacturing a board according to any one of (1) to (4) or the board according to (5).

(9) The method for manufacturing a board having a plated layer according to (8), wherein the plasma treatment is at least one kind of plasma treatment selected from an $H_2$/Ar plasma treatment and an $O_2$/Ar plasma treatment.

(10) A method for manufacturing a board having a plated layer, comprising: forming a plated layer by performing plating on a surface of a board acquired by the method for manufacturing a board according to any one of (1) to (4) or the board according to (5); and performing a laser annealing treatment on the formed plated layer.

(11) The method for manufacturing a board having a plated layer according to (10), wherein the forming of the plated layer includes: forming an electroless plated layer by performing electroless plating on a surface of a board acquired by the method for manufacturing a board according to any one of (1) to (4) or the board according to (5) and forming an electrolytic plated layer by performing electrolytic plating on the electroless plated layer; or forming a dry plated layer by performing dry plating on a surface of a board acquired by the method for manufacturing a board according to any one of (1) to (4) or the board according to (5) and forming an electrolytic plated layer by performing electrolytic plating on the dry plated layer.

(12) The method for manufacturing a board having a plated layer according to (10) or (11), wherein a wavelength of a laser light irradiated on the plated layer is 600 nm or less when the laser annealing treatment is performed.

Advantageous Effects of Invention

The disclosure provides the method for manufacturing a board with a roughened surface and the method for manufacturing a board having a plated layer, which facilitate the manufacturing of the board having a plated layer. In addition, the present disclosure can provide the board with a roughened surface.

Brief Description of Drawings

FIG. 1 is SEM images of an ABF film acquired in Example 1 on which laser ablation was performed and an ABF film acquired in Comparative Example 1 on which wet roughening was performed;

FIG. 2 illustrates functional group amounts (area ratios) obtained by performing an XPS observation on the surfaces of an ABF film, the ABF film acquired in Example 1 on which laser ablation has been performed, and the ABF film acquired in Comparative Example 1 on which wet roughening has been performed, acquiring C1s (1s orbital of carbon atoms) spectra, and performing peak splitting;

FIG. 3 illustrates peel strength of boards having copper plated layers acquired in Example 2 and Comparative Example 2;

FIG. 4 illustrates a functional group amount (area ratio) obtained by performing an XPS observation on the surface of an ABF film acquired in Example 3 on which an $H_2/Ar$ plasma treatment and an $O_2/Ar$ plasma treatment have been performed, acquiring a C1s (1s orbital of carbon atoms) spectrum, and performing peak splitting; and

FIG. 5 illustrates peel strength of a board having a copper plated layer acquired in Example 3.

Description of Embodiments

The following describes in detail a method for manufacturing a board with a roughened surface, a board with a roughened surface, and a method for manufacturing a board having a plated layer of the embodiment.

(Method for Manufacturing Board with Roughened surface)

The method for manufacturing a board with a roughened surface of the embodiment is a method for manufacturing a board with a surface roughened for wiring formation and a method for manufacturing a board that includes a step of performing laser ablation on a board containing a resin at least on a surface and in which a laser light irradiated in the laser ablation is a laser light having a pulse width of 1 ps or less, a wavelength of 320 nm or more, and an output of 1 W or less.

With the method for manufacturing a board with a roughened surface of the embodiment, performing the laser ablation under specific conditions allows forming a large number of fine unevenness on the surface of the acquired board. The acquired board has an improved functional group amount (amount of COO group and C=O group) of the surface. The board acquired by the embodiment (the board with a roughened surface) has a large number of fine unevenness and a large functional group amount. Therefore, a plated layer formed on the acquired board has an excellent adhesive strength between the plated layer and the board.

The board containing a resin at least on a surface on which the laser ablation is to be performed is not specifically limited, including conventional boards for wiring formation. Examples of the resin include polytetrafluoroethylene (PTFE), liquid crystal polymer (LCP), polyphenylene ether (PPE), modified polyphenylene ether (m-PPE), polyimide (PI), modified polyimide (MPI), bismaleimide triazine resin (BT), epoxy resin, and Low-k epoxy resin (low-dielectric constant (Low-Dk) and low-dielectric loss tangent (Low-Df) epoxy resin). The resin may be a high frequency-compatible low-dielectric board applicable to high-speed communications (for example, fifth-generation mobile communication systems and sixth-generation mobile communication systems) and millimeter-wave compatible communications (for example, automotive applications). In the embodiment, the laser ablation is performed on a board. The laser ablation is performed by irradiating a surface of the board with a specific laser light, and more specifically, by irradiating the surface of the board on which the resin exists with a laser light.

The surface of the board only needs to contain a resin and may further contain components other than the resin. Examples of the components other than the resin include glass fiber, a silica-based filler, a ceramic-based filler, $Al_2O_3$, AlN, and BN.

The board may be a board having a structure with one layer that is formed only from a layer formed from the resin or may be a board having a structure with two or more layers (multi-layer structure) that has a layer formed from the resin and another layer. The other layer is not specifically limited.

In the embodiment, the laser light irradiated in the laser ablation is a laser light having a pulse width of 1 ps or less, a wavelength of 320 nm or more, and an output of 1 W or less. Using the laser light allows forming fine unevenness on the board surface and increasing the functional group amount (amount of COO group and C=O group) of the board surface.

The laser light may be a laser light having a pulse width of 0.1 ps or more in one aspect. The pulse width may be 0.9 ps or less, or may be 0.85 ps or less in some embodiments. The pulse width may be 0.2 ps or more, or may be 0.3 ps or more in some embodiments.

The laser light may be a laser light having a wavelength of 1064 nm or less in one aspect. The wavelength of a laser light differs depending on a light source (laser medium). and for example, using Yb:YAG allows emitting a laser light having a wavelength of 1030 nm and a laser light having a wavelength of 515 nm (second harmonic) , and using YAG allows emitting a laser light having a wavelength of 1064 nm, a laser light having a wavelength of 532 nm (second harmonic), and a laser light having a wavelength of 355 nm (third harmonic). As the light source, for example, Yb:YAG, YAG, or the like can be used.

The laser light is a laser light having an output of 0.05 W or more in one aspect. The output may be 0.8 W or less, or may be 0.6 W or less in some embodiments. In addition, the output may be 0.07 W or more, or may be 0.1 W or more in some embodiments.

Energy fluence in performing the laser ablation may be 15 $\mu$J/cm$^2$ or less, may be 13 $\mu$J/cm$^2$ or less, or may be 10 $\mu$J/cm$^2$ or less in some embodiments. In addition, the energy fluence may be 1 $\mu$J/cm$^2$ or more, or may be 5 $\mu$J/cm$^2$ or more in some embodiments.

An apparatus used in the laser ablation only needs to be capable of emitting the laser light, and is not especially limited. Examples of the apparatus include LodeStone (manufactured by Esi) and Monaco series (COHERENT, Inc.).

(Board with Roughened surface)

The board with a roughened surface of the embodiment is a board that contains a resin at least on a surface and has an arithmetic mean height Sa of 50 to 200 nm and a functional group amount (area ratio) in a C1s spectrum obtained from an XPS (X-ray photoelectron spectroscopy) spectrum of 10% or more. The board is usually used as a board for wiring formation.

The board with a roughened surface of the embodiment can be manufactured by the method for manufacturing a board with a roughened surface described above.

When the arithmetic mean height Sa is within the range, it is indicated that the board has fine unevenness, that is, the surface is roughened. When the functional group amount (area ratio) in the C1s spectrum obtained from the XPS spectrum is 10% or more, it is indicated that the functional group amount (amount of COO group and C=O group) of the board surface is sufficiently high.

A plated layer formed on the board with a roughened surface of the embodiment may have an excellent adhesive strength between the plated layer and the board.

The arithmetic mean height Sa of the board with a roughened surface can be measured using a laser roughness meter.

The functional group amount (area ratio) in the C1s spectrum obtained from the XPS spectrum can be calculated by performing peak splitting on a peak of the C1s (1s orbital of carbon atoms) in the XPS spectrum, calculating the peak area derived from the COO group and the peak area derived from the C=O group, and dividing the sum of the peak areas by the peak area of all C1s, as shown in the following formula.

$$\text{Functional group amount (area ratio)} = [(\text{peak area derived from COO group} + \text{peak area derived from C=O group})/\text{peak area of all C1s}] \times 100$$

The functional group amount (area ratio) is 10% or more, may be 11% or more, or may be 12% or more in some embodiments. The functional group amount (area ratio) is usually 20% or less, may be 17% or less, or may be 15% or less in some embodiments.

(Method for Manufacturing Board Having Plated Layer)

As the method for manufacturing a board having a plated layer, the present disclosure has three broadly divided embodiments. Since the board having a plated layer acquired by the method for manufacturing a board having a plated layer has an excellent peel strength of the plated layer, the board can be used for various applications, such as high-density micro wiring boards, which are required in high-speed communications (such as fifth-generation mobile communication systems and sixth-generation mobile communication systems) and millimeter-wave compatible communications (such as automotive applications). Examples of a metal constituting the plated layer include copper, gold, argentum, nickel, chrome, and aluminum. The metal may be copper or gold, and may be copper in some embodiments.

The method for manufacturing a board having a plated layer of Embodiment-A is a method for manufacturing a board having a plated layer. The method includes a step of forming an electroless plated layer by performing electroless plating on the surface of a board acquired by the method for manufacturing a board of the above embodiment or the board of the above embodiment, a step of forming an electrolytic plated layer by performing electrolytic plating on the electroless plated layer, and a step of performing an annealing treatment on the board on which the electrolytic plated layer is formed.

The method for manufacturing a board having a plated layer of Embodiment-B is a method for manufacturing a board having a plated layer. The method includes a step of forming a dry plated layer by performing dry plating on the surface of a board acquired by the method for manufacturing a board of the above embodiment or the board of the above embodiment, a step of forming an electrolytic plated layer by performing electrolytic plating on the dry plated layer, and a step of performing an annealing treatment on the board on which the electrolytic plated layer is formed.

The method for manufacturing a board having a plated layer of Embodiment-C is a method for manufacturing a board having a plated layer. The method includes a step of forming a plated layer by performing plating on the surface of a board acquired by the method for manufacturing a board of the above embodiment or the board of the above embodiment, and a step of performing a laser annealing treatment on the formed plated layer.

The method for manufacturing a board having a plated layer of Embodiment-A includes a step of forming an electroless plated layer by performing electroless plating on the surface of a board acquired by the method for manufacturing a board of the above embodiment or the board of the above embodiment. An electroless plating solution can be selected according to a metal type constituting the plated layer, and any electroless plating solution including a publicly known autocatalytic electroless plating solution and the like can be used without specific limitations. As the electroless plating solution, an electroless copper plating solution, an electroless gold plating solution, an electroless silver plating solution, an electroless nickel plating solution, an electroless chrome plating solution, or the like can be used. For the application of wiring boards, the electroless copper plating solution is usually used. As the plating conditions of the electroless plating, publicly known conditions can be appropriately used. The electroless plated layer may have an average thickness of 600 nm or less, may have an average thickness of 240 nm to 160 nm, or may have an average thickness of 220 nm to 180 nm in some embodiments. The electroless plated layer may be an electroless copper plated layer in one aspect. A board having a plated layer may be acquired by the method for manufacturing a board having a plated layer of Embodiment-A especially because the board is strongly coupled to the plated layer and has a high peel strength. A board having a plated layer may be acquired by the methods for manufacturing a board having a plated layer of Embodiment-A, Embodiment-B, and Embodiment-C because the board has an excellent adhesive strength between the plated layer and the board without providing an adhesive layer formed from Cr or Ti that was provided in performing the conventional dry plating.

The method for manufacturing a board having a plated layer of Embodiment-B includes a step of forming a dry plated layer by performing dry plating on the surface of a board acquired by the method for manufacturing a board of the above embodiment or the board of the above embodiment. Examples of the dry plating includes a sputtering method, an ion plating method, and a vacuum vapor deposition method. The dry plating may be the sputtering method from the aspect of the adhesion with a board. That is, the dry plated layer may be a sputtered layer in one aspect. As a target in performing the dry plating, copper, gold, argentum, nickel, chrome, aluminum, or the like can be used, and copper is usually used for the application of wiring boards.

The dry plating can be performed by appropriately applying publicly known conditions. That is, the dry plating can be performed by the publicly known sputtering method, ion plating method, vacuum vapor deposition method, or the like. The dry plated layer may have an average thickness of 600 nm or less, may have an average thickness of 250 nm to 150 nm, or may have an average thickness of 240 nm to 160 nm in some embodiments. The dry plated layer may be a dry copper plated layer in one aspect. The board having a plated layer acquired by the method for manufacturing a board having a plated layer of Embodiment-B has a sufficiently high peel strength even though the plated layer adjacent to the board is a dry plated layer formed by the dry plating by which it is generally difficult to couple to a board. From the aspect of allowing the reduction of environmental load, the dry plating may be performed because the dry plating tends to have less environmental load compared with the electroless plating that is a kind of wet plating.

The method for manufacturing a board having a plated layer of Embodiment-B may include, before the step of forming a dry plated layer, a step of performing a plasma treatment on the surface of a board acquired by the method for manufacturing a board of the above embodiment or the board of the above embodiment in one aspect. The step of performing a plasma treatment may be provided because the functional group amount (area ratio) in the C1s spectrum obtained from the XPS spectrum of the board can be further improved. While it is the most effective to perform the step of performing a plasma treatment by the method for manufacturing a board having a plated layer of Embodiment-B, the step of performing a plasma treatment may be performed before the step of forming an electroless plated layer in another method, for example, in the method for manufacturing a board having a plated layer of Embodiment-A.

The plasma treatment may be at least one kind of plasma treatment selected from an $H_2$/Ar plasma treatment and an $O_2$/Ar plasma treatment. The $H_2$/Ar plasma treatment is a method of performing a plasma treatment on a board using hydrogen and argon, and the $O_2$/Ar plasma treatment is a method of performing a plasma treatment on a board using oxygen and argon, and the $H_2$/Ar plasma treatment and the $O_2$/Ar plasma treatment can be each performed by appropriately applying publicly known conditions. As the plasma treatment, the $H_2$/Ar plasma treatment and the $O_2$/Ar plasma treatment may be performed, and the $O_2$/Ar plasma treatment may be performed after performing the $H_2$/Ar plasma treatment in some embodiments. Performing the $H_2$/Ar plasma treatment can provide a clean surface, and subsequently performing the $O_2$/Ar plasma treatment can introduce the functional group.

The method for manufacturing a board having a plated layer of Embodiment-A includes a step of forming an electrolytic plated layer by performing electrolytic plating on the electroless plated layer. The method for manufacturing a board having a plated layer of Embodiment-B includes a step of forming an electrolytic plated layer by performing electrolytic plating on the dry plated layer. These steps differ in whether an object on which electrolytic plating is performed is an electroless plated layer or a dry plated layer, and other than that, these steps can be performed similarly.

As an electrolytic plating solution, an electrolytic copper plating solution, an electrolytic gold plating solution, an electrolytic silver plating solution, an electrolytic nickel plating solution, an electrolytic chrome plating solution, an electrolytic tin plating solution, or the like can be used. For the application of wiring boards, the electrolytic copper plating solution is usually used. As the plating conditions of the electrolytic plating, publicly known conditions can be appropriately applied. In some embodiments, as the electrolytic plating, a solid electrolyte deposition (SED) that is a plating method using a solid-state electrolyte membrane may be employed. For the application of wiring boards, the electrolytic plated layer may have an average line width of wiring (simply referred to also as width) of 30 $\mu$m or less, may have an average line width of 10 $\mu$m or less, or may have an average line width of 5 $\mu$m or less in some embodiments. In addition, the average line width may be 1 $\mu$m or more. From the aspect of micro wiring, the aspect ratio (thickness/width) of the thickness to the width of the wiring may be 0.85 to 1.15, or may be 0.9 to 1.1 in some embodiments. The electrolytic plated layer may be an electrolytic copper plated layer in one aspect. The electroless plated layer and the electrolytic plated layer, or the dry plated layer and the electrolytic plated layer may be layers formed from the same type of metal, or may be layers formed from copper in some embodiments.

The method for manufacturing a board having a plated layer of Embodiment-A includes a step of performing an annealing treatment on the board on which the electrolytic plated layer is formed. The method for manufacturing a board having a plated layer of Embodiment-B also includes a step of performing an annealing treatment on the board on which the electrolytic plated layer is formed.

The annealing treatment is generally performed by heating the board on which an electrolytic plated layer is formed. While the heating temperature varies depending on the type of a resin constituting the board, the type of metal constituting the plated layer, and the like, it is, for example, 100°C to 210°C, and may be 110°C to 200°C in some embodiments. The annealing treatment is usually performed by heating the board at a temperature, which is the glass transition point (Tg) or more of the resin constituting the board, and for a time period in which its shape retention is secured. In the annealing treatment, the temperature may be increased in phases from a low temperature in one aspect. For example, when Tg of the resin constituting the board is 150°C, a low-temperature annealing treatment can be performed at 100°C to 140°C, or at 110°C to 140°C in some embodiments, and subsequently, a high-temperature annealing treatment can be performed at 150°C to 210°C, or at 150°C to 200°C in some embodiments. When the annealing treatment is performed at a constant temperature, for example, the annealing treatment is performed at 150°C to 210°C, or at 160°C to 200°C in some embodiments. In the annealing treatment, heating at a temperature of Tg of the resin or more is performed usually for 10 minutes to 90 minutes, or for 30 minutes to 60 minutes in some embodiments. When the annealing treatment is performed by increasing the temperature in phases from a low temperature, each phase is performed usually for 10 minutes to 90 minutes, or for 30 minutes to 60 minutes in some embodiments.

The annealing treatment may be performed in air, or may be performed in an inert gas, such as nitrogen and noble gas. From the aspect of the cost, the annealing treatment may be performed in air, and from the aspect of suppressing side reactions, it may be performed in an inert gas.

While the annealing treatment may be performed under normal pressure, under reduced pressure, or under increased pressure, it is usually performed under normal pressure.

While the annealing treatment is generally performed by heating the board on which an electrolytic plated layer is formed, it may be performed by performing a laser annealing treatment on the electrolytic plated layer of the board on which an electrolytic plated layer is formed. The laser annealing treatment is synonymous with the laser annealing treatment in the method for manufacturing a board having a plated layer of Embodiment-C.

The method for manufacturing a board having a plated layer of Embodiment-C includes a step of forming a plated layer by performing plating on the surface of a board acquired by the method for manufacturing a board of the above embodiment or the board of the above embodiment. The plating in the step is not specifically limited, and examples of the plating include electroless plating, dry plating, electrolytic plating, and any combination thereof. The step of forming a plated layer may have a step of forming an electroless plated layer by performing electroless plating on the surface of a board acquired by the method for manufacturing a board of the above embodiment or the board of the above embodiment and a step of forming an electrolytic plated layer by performing electrolytic plating on the electroless plated layer, or may include a step of forming a dry plated layer by performing dry plating on the surface of a board acquired by the method for manufacturing a board of the above embodiment or the board of the above embodiment, and a step of forming an electrolytic plated layer by performing electrolytic plating on the dry plated layer. That is, by the methods described in Embodiment-A and Embodiment-B described above, the electroless plated layer and the electrolytic plated layer may be formed, or the dry plated layer and the electrolytic plated layer may be formed.

The method for manufacturing a board having a plated layer of Embodiment-C includes a step of performing a laser annealing treatment on the formed plated layer. The laser annealing treatment is a method for performing an annealing treatment on the portion irradiated with a laser light by irradiating the formed plated layer with the laser light. The wavelength of the laser light irradiated on the plated layer may be a wavelength that can be absorbed by the plated layer. While the wavelength of the laser light irradiated on the plated layer varies depending on the metal type of the plated layer, it is usually 600 nm or less, and may be 550 nm or less in some embodiments. While the lower limit of the wavelength is not specifically limited, for example, it may be 200 nm or more in some embodiments.

Irradiation conditions of the laser light are not specifically limited insofar as the interface temperature between the plated layer and the board is the glass transition point or more of the resin constituting the portion of the board. The irradiation conditions can be appropriately set depending on the types of the device and the resin, the metal type, thickness, and the like of the plated layer.

While the laser annealing treatment varies depending on the area and the like of the portion to be annealed, it is desirable that the laser annealing treatment exhibits a sufficient peel strength generally in a brief time, for example, within 10 minutes, or within 3 minutes of treatment in some embodiments, compared with the annealing treatment by heating. Since the laser annealing treatment allows local heating of interface between the board and the plated layer by a laser light, heating can be performed without concerns about shape retention of the board. In view of this, heating may be performed by a laser light to a temperature exceeding the temperature (for example, 200°C, although it varies depending on the type of the resin) at which the shape retention can be secured in a case of general heating, that is, in a case of heating the entire board.

Examples

While the following describes the embodiments using Examples, the present disclosure is not limited thereto.

In Examples, ABF films (ABF GX92, manufactured by Ajinomoto Fine-Techno Co., Inc.) were used. ABF GX92 is distributed in a state where a layer formed from an insulating material (epoxy resin containing a silica-based filler) is disposed on a PET film. In Examples, ABF GX92 in which the PET film was peeled off and the layer formed from the insulating material (epoxy resin containing a silica-based filler) was attached on a supporting member (epoxy resin containing glass fiber) was used as the ABF film (board). In Examples, not the surface on the supporting member side, but the surface on the side of the layer formed from the insulating material (hereinafter simply referred to as the surface) was a target on which laser ablation or wet roughening was performed.

[Example 1]

Laser ablation (target roughness Sa 200 nm) was performed by irradiating the surface of the ABF film with a laser light under the conditions below.

(Laser irradiation conditions)

Device: LodeStone (manufactured by Esi)

Wavelength: 515 nm

Pulse Width: 0.8 ps

Beam Diameter: $\varphi$ 10 $\mu$m

Output: 0.15 W

Repetition Frequency: 100 KHz

Scanning Rate: 500 mm/s

Overlap: 5 $\mu$m

[Comparative Example 1]

Wet roughening (target roughness Sa 200 nm) was performed on the surface of the ABF film by a desmear process with permanganic acid.

[SEM Observation]

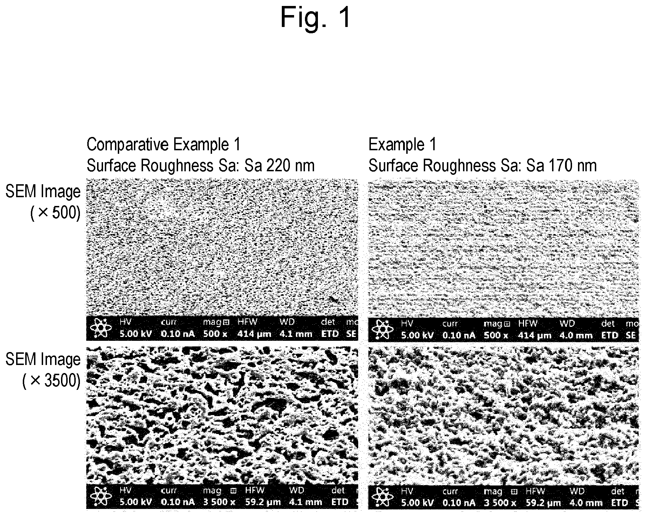

An SEM observation was performed on the surfaces of the ABF film acquired in Example 1 on which the laser ablation was performed and the ABF film acquired in Comparative Example 1 on which the wet roughening was performed under the conditions below to acquire SEM images. The surface roughness Sa (arithmetic mean heights) was obtained with a confocal laser roughness meter. The surface roughness Sa of the ABF film acquired in Example 1 on which the laser ablation was performed was 170 nm, and the surface roughness Sa of the ABF film acquired in Comparative Example 1 on which the wet roughening was performed was 220 nm. Note that Sa is the arithmetic mean height of a contour curved surface and means the average absolute value of the vertical coordinate values z (x, y) in reference region A. The SEM images are illustrated in FIG. 1.

From FIG. 1, while three-dimensional holes (deep holes) were formed in the ABF film acquired in Comparative Example 1 on which the wet roughening was performed, a large number of relatively small unevenness were formed on the surface of the ABF film acquired in Example 1 on which the laser ablation was performed. The ABF film acquired in Example 1 on which the laser ablation was performed had a larger specific surface area.

[XPS Observation]

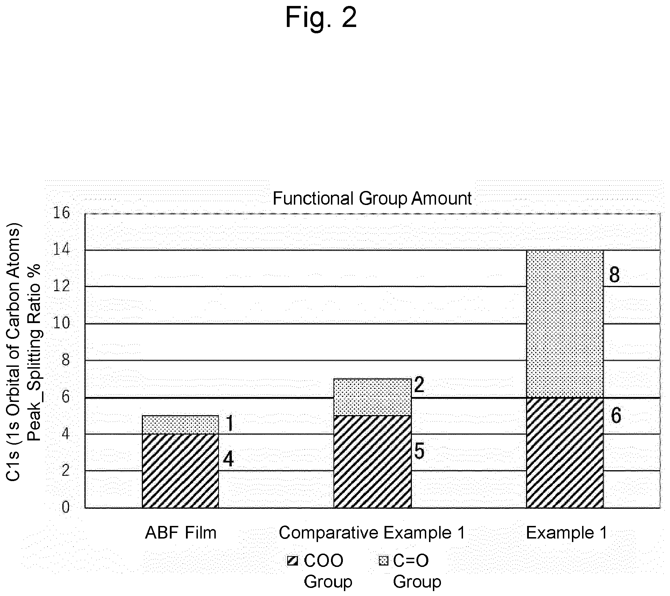

An XPS observation was performed under the conditions below on the surfaces of an ABF film, the ABF film acquired in Example 1 on which the laser ablation was performed, and the ABF film acquired in Comparative Example 1 on which the wet roughening was performed, C1s (1s orbital of carbon atoms) spectra were acquired, and peak splitting was performed to calculate the functional group amounts (area ratios). As the functional groups, the COO group and the C=O group were subject to analysis by the peak splitting. The functional group amounts are illustrated in FIG. 2.

It can be seen from FIG. 2 that in the ABF film, the functional group amount increases by performing the processes of Example 1 and Comparative Example 1. Especially in Example 1, compared with the ABF film before the processes and the ABF film acquired in Comparative Example 1 on which the wet roughening was performed, the functional group amount was confirmed to substantially increase. The increase of the functional group amount is considered to be a change with which the adhesive strength with the plated layer can expect to improve in some embodiments.

[Example 2]

Electroless copper plating was performed on the surface of the ABF film acquired in Example 1 on which the laser ablation was performed, under the conditions below to form an electroless copper plated layer. Subsequently, electrolytic copper plating was performed on the electroless copper plated layer under the conditions below to form an electrolytic copper plated layer.

(Electroless copper plating)

Electroless copper plating solution: PEA ver.3 (manufactured by C. Uyemura & Co., Ltd.)

Treatment temperature: 33°C

Immersion period: 30 minutes

Average thickness of electroless copper plated layer: 0.5 $\mu$m

(Electrolytic copper plating)

Electrolytic copper plating solution: Prepared based on Cover Cream 125A 125B (manufactured by Rohm and Haas Company)

Current density: 2 A/dm$^2$

Plating time: 60 minutes, normal temperature

Average thickness of electrolytic copper plated layer: 20 $\mu$m

A heat treatment (annealing treatment) was performed on the board on which the electrolytic copper plated layer was formed, under air atmosphere at 180°C for 30 minutes to acquire a board having a copper plated layer.

[Comparative Example 2]

Electroless copper plating was performed on the surface of the ABF film acquired in Comparative Example 1 on which the wet roughening was performed, under the conditions below to form an electroless copper plated layer. Subsequently, electrolytic copper plating was performed on the electroless copper plated layer under the conditions below to form an electrolytic copper plated layer.

(Electroless copper plating)

Electroless copper plating solution: PEA ver.3 (manufactured by C. Uyemura & Co., Ltd.)

Treatment temperature: 33°C

Immersion period: 30 minutes

Average thickness of electroless copper plated layer: 0.5 $\mu$m

(Electrolytic copper plating)

Electrolytic copper plating solution: Prepared based on Cover Cream 125A·125B (manufactured by Rohm and Haas Company)

Current density: 2 A/dm$^2$

Plating time: 30 minutes

Average thickness of electrolytic copper plated layer: 20 $\mu$m

A heat treatment (annealing treatment) was performed on the board on which the electrolytic copper plated layer was formed, under air atmosphere at 180°C for 30 minutes to acquire a board having a copper plated layer.

[Peel Strength Measurement]

The peel strength of the boards having the copper plated layers acquired in Example 2 and Comparative Example 2 was measured.

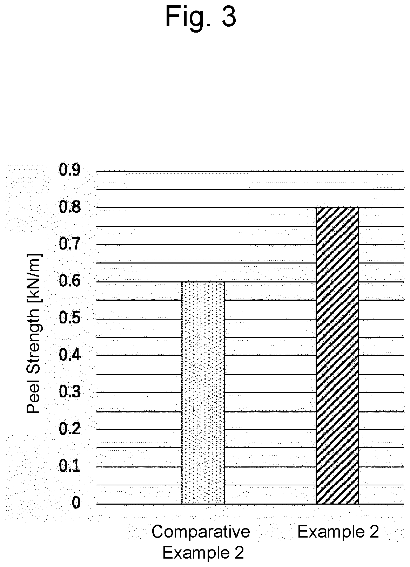

A 10 mm width slit was made in the electrolytic copper plated layers using a cutter, and the peel strength (kN/m) was measured with a peel strength tester (Digital Force Gauge ZTA-DPU, manufactured by IMADA CO., LTD.). The measurement results of the peel strength were shown in FIG. 3.

It was indicated from FIG. 3 that in Example 2, the peel strength substantially improves compared with Comparative Example 2. In Comparative Example 2, it was also possible to achieve a general target peel strength (0.6 kN/m). However, since the board having the copper plated layer acquired in Example 2 had further improved peel strength, it was indicated that the board having the copper plated layer acquired in Example 2 is useful for a high-density micro wiring board.

[Example 3]

An H$_2$/Ar plasma treatment was performed on the ABF film acquired in Example 1 on which the laser ablation was performed, under the conditions below, and subsequently, an O$_2$/Ar plasma treatment was performed.

(H$_2$/Ar Plasma Treatment Conditions)

Hydrogen 3%/Argon 97% (volume fraction)

Device: High-speed sputtering apparatus (manufactured by Shimadzu Corporation)

Pressure: 30 Pa

Output: 1750 W

Treatment time: 60 seconds

TS (distance between anode plasma source and board sample (stage)): 180 mm

BGP (background pressure): 0.5 Pa

($O_2$/Ar Plasma Treatment Conditions)

Oxygen 95%/argon 5% (volume fraction)

Device: High-speed sputtering apparatus (manufactured by Shimadzu Corporation)

Pressure: 30 Pa

Output: 2100 W

Treatment time: 180 seconds

TS: 180 mm

BGP: 0.5 Pa

Subsequently, copper sputtering was performed on the surface of the acquired ABF film on which the $H_2$/Ar plasma treatment and the $O_2$/Ar plasma treatment were performed, under the conditions below to form a sputtered copper layer (dry copper plated layer). Subsequently, electrolytic copper plating was performed on the sputtered copper layer under the conditions below to form an electrolytic copper plated layer.

(Copper sputtering)

Sputtering source: copper

Power source: 35 KW

Argon flow rate: 270 sccm

Gas pressure: 1.6 Pa

Sputtering time: 10 seconds

TS: 180 mm

BGP: 0.5 Pa

Average thickness of sputtered copper layer: 0.5 $\mu$m

(Electrolytic copper plating)

Electrolytic copper plating solution: Prepared based on Cover Cream 125A 125B (manufactured by Rohm and Haas Company)

Current density: 2 A/dm$^2$

Plating time: 30 minutes

Average thickness of electrolytic copper plated layer: 20 $\mu$m

A heat treatment (low-temperature annealing treatment) was performed on the board on which the electrolytic copper plated layer was formed, under air atmosphere at 120°C for 30 minutes, and subsequently, a heat treatment (high-temperature annealing treatment) was performed at 200°C for 1 hour to acquire a board having a copper plated layer.

[XPS Observation]

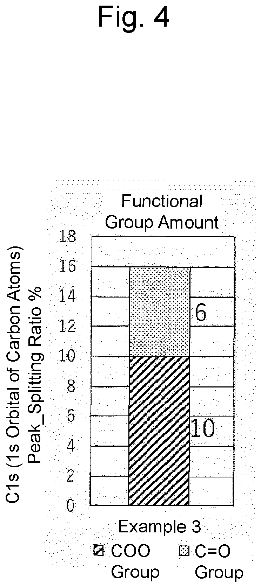

An XPS observation was performed under the conditions below on the surface of the ABF film acquired in Example 3 on which the H$_2$/Ar plasma treatment and the O$_2$/Ar plasma treatment were performed, a C1s (1s orbital of carbon atoms) spectrum was acquired, and peak splitting was performed to calculate the functional group amount (area ratio). As the functional groups, the COO group and the C=O group were subject to analysis by the peak splitting. The functional group amount is illustrated in FIG. 4.

From FIG. 4 and FIG. 2, it was confirmed that the functional group amount was further increased by performing the H$_2$/Ar plasma treatment and the O$_2$/Ar plasma treatment. The increase of the functional group amount is considered to be a change with which the adhesive strength with the plated layer can expect to improve in some embodiments.

[Peel Strength Measurement]

The peel strength of the board having the copper plated layer acquired in Example 3 was measured.

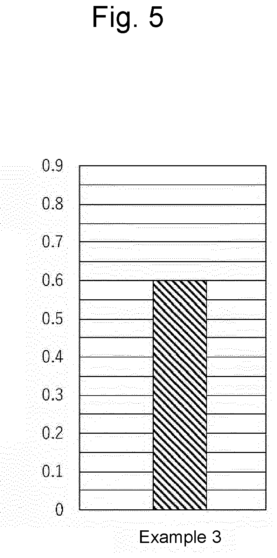

A 10 mm width slit was made in the electrolytic copper plated layer using a cutter, and the peel strength (kN/m) was measured with the peel strength tester (Digital Force Gauge ZTA-DPU, manufactured by IMADA CO., LTD.). The measurement result of the peel strength is shown in FIG. 5.

Generally, it is known that an adhesion is low even when a copper layer is formed to a resin by sputtering, and an adhesive layer (for example, a sputtered Ti layer or a sputtered Cr layer) has been conventionally provided between the resin and the copper layer. However, it was found from FIG. 5 that, in Example 3, it is possible to achieve the general target peel strength (0.6 kN/m).

[Example 4]

An electroless copper plated layer and an electrolytic copper plated layer were formed on the surface of the ABF film acquired in Example 1 on which the laser ablation was performed by the method described in Example 2.

A board having a copper plated layer was acquired by performing a laser annealing treatment on the board on which the electrolytic copper plated layer was formed, under the conditions below.

(Laser annealing treatment)

The laser annealing treatment was performed by irradiating the electrolytic copper plated layer with a laser light under the conditions below.

Device: LDH-G0610 (manufactured by Spectronix Corporation)

Wavelength: 532 nm

Pulse frequency: 200 kHz (step 0.25 $\mu$m)

Speed: 50 mm/sec

Beam diameter after light focusing: approximately $\varphi$ 19 $\mu$m

Beam diameter after defocusing: $\varphi$ approximately 5 mm

Output: 20 W

Laser irradiation time: 1 minute, 2 minutes, 3 minutes, 5 minutes, 10 minutes, 20 minutes, 30 minutes, 60 minutes, 90 minutes, or 120 minutes

[Comparative Example 3]

A board having a copper plated layer was acquired similarly to Example 4 except that the laser annealing treatment was not performed.

[Peel Strength Measurement]

The peel strength of the boards having the copper plated layers acquired in Example 4 and Comparative Example 3 was measured.

A 10 mm width slit was made in the electrolytic copper plated layers using a cutter, and the peel strength (kN/m) was measured with the peel strength tester (Digital Force Gauge ZTA-DPU, manufactured by IMADA CO., LTD.). The laser irradiation time and the measurement results of the peel strength were shown in Table 1. Note that the laser irradiation time of 0 minutes in Table 1 corresponds to Comparative Example 3.

[Table 1]

| Laser Irradiation Time | Peel Strength [kN/m] |
|---|---|
| | |
| 0 minutes (Without Laser Irradiation) | 0.539 |
| 1 minute | 0.621 |
| 2 minutes | 0.665 |
| 3 minutes | 0.771 |
| 5 minutes | 0.790 |
| 10 minutes | 0.853 |
| 20 minutes | 0.932 |
| 30 minutes | 0.891 |
| 60 minutes | 0.866 |
| 90 minutes | 0.828 |
| 120 minutes | 0.929 |

It was found from Table 1 that the board having a copper plated layer that has improved peel strength and exceeds the general target peel strength (0.6 kN/m) is acquired by performing the laser annealing treatment, compared with a case where the laser annealing treatment is not performed. It was indicated that the laser annealing treatment allows acquiring the board having a copper plated layer with excellent peel strength in a shorter time than a general treatment by heat.

Upper limit values and/or lower limit values of respective numerical ranges described in this description can be appropriately combined to specify an intended range. For example, upper limit values and lower limit values of the numerical ranges can be appropriately combined to specify an intended range, upper limit values of the numerical ranges can be appropriately combined to specify an intended range, and lower limit values of the numerical ranges can be appropriately combined to specify an intended range.

While the embodiments have been described in detail, the specific configuration is not limited to the embodiments. Design changes within a scope not departing from the gist of the present disclosure are included in the present disclosure.

**Claims**

1. A method for manufacturing a board with a surface roughened for wiring formation, the method for manufacturing a board comprising

    performing laser ablation on a board containing a resin at least on a surface of the board,
    wherein a laser light irradiated in the laser ablation is a laser light having a pulse width of 1 ps or less, a wavelength of 320 nm or more, and an output of 1 W or less.

2. The method for manufacturing a board according to claim 1,
    wherein the laser light is a laser light having a pulse width of 0.1 ps or more.

3. The method for manufacturing a board according to claim 1 or 2,
    wherein the laser light is a laser light having a wavelength of 1064 nm or less.

4. The method for manufacturing a board according to any one of claims 1 to 3,
    wherein the laser light is a laser light having an output of 0.05 W or more.

5. A board comprising

    a resin at least on a surface of the board,
    wherein the surface has an arithmetic mean height Sa of 50 to 200 nm and a functional group amount (area ratio) in a C1s spectrum obtained from an XPS spectrum of 10% or more.

6. A method for manufacturing a board having a plated layer, comprising:

    forming an electroless plated layer by performing electroless plating on a surface of a board acquired by the method for manufacturing a board according to any one of claims 1 to 4 or the board according to claim 5;
    forming an electrolytic plated layer by performing electrolytic plating on the electroless plated layer; and
    performing an annealing treatment on the board on which the electrolytic plated layer is formed.

7. A method for manufacturing a board having a plated layer, comprising:

    forming a dry plated layer by performing dry plating on a surface of a board acquired by the method for manufacturing a board according to any one of claims 1 to 4 or the board according to claim 5;
    forming an electrolytic plated layer by performing electrolytic plating on the dry plated layer; and
    performing an annealing treatment on the board on which the electrolytic plated layer is formed.

8. The method for manufacturing a board having a plated layer according to claim 7, comprising

    before the forming of the dry plated layer,
    performing a plasma treatment on a surface of a board acquired by the method for manufacturing a board according to any one of claims 1 to 4 or the board according to claim 5.

9. The method for manufacturing a board having a plated layer according to claim 8,
    wherein the plasma treatment is at least one kind of plasma treatment selected from an $H_2$/Ar plasma treatment and an $O_2$/Ar plasma treatment.

10. A method for manufacturing a board having a plated layer, comprising:

    forming a plated layer by performing plating on a surface of a board acquired by the method for manufacturing a board according to any one of claims 1 to 4 or the board according to claim 5; and
    performing a laser annealing treatment on the formed plated layer.

11. The method for manufacturing a board having a plated layer according to claim 10,
    wherein the forming of the plated layer includes:

    forming an electroless plated layer by performing electroless plating on a surface of a board acquired by the method for manufacturing a board according to any one of claims 1 to 4 or the board according to claim 5 and forming an electrolytic plated layer by performing electrolytic plating on the electroless plated layer; or forming a dry plated layer by performing dry plating on a surface of a board acquired by the method for manufacturing a board according to any one of claims 1 to 4 or the board according to claim 5 and forming an electrolytic plated layer by performing electrolytic plating on the dry plated layer.

12. The method for manufacturing a board having a plated layer according to claim 10 or 11,
wherein a wavelength of a laser light irradiated on the plated layer is 600 nm or less when the laser annealing treatment is performed.

# Fig. 1

Comparative Example 1
Surface Roughness Sa: Sa 220 nm

Example 1
Surface Roughness Sa: Sa 170 nm

SEM Image
(×500)

SEM Image
(×3500)

# Fig. 2

# Fig. 3

# Fig. 4

# Fig. 5

Example 3

Europäisches
Patentamt

European
Patent Office

Office européen
des brevets

# EUROPEAN SEARCH REPORT

Application Number

EP 23 15 5088

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/288577 A1 (OYA SATOSHI [JP] ET AL) 10 September 2020 (2020-09-10) | 1-7 | INV. H05K3/38 |
| Y | * paragraph [0064] – paragraph [0096]; | 8,9 | |
| A | figures 3A-3E; tables 2-4 * | 10-12 | ADD. H05K3/00 |
| Y | US 2018/007800 A1 (SHINDOU NATSUKO [JP] ET AL) 4 January 2018 (2018-01-04) | 8,9 | H05K3/18 H05K3/16 |
| A | * paragraph [0115] – paragraphs [0124], [0155] * | 7,11 | |

TECHNICAL FIELDS
SEARCHED (IPC)

H05K

The present search report has been drawn up for all claims

| Place of search | Date of completion of the search | Examiner |
|---|---|---|
| The Hague | 15 August 2023 | Zimmer, René |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 15 5088

This annex lists the patent family members relating to the patent documents cited in the above-mentioned European search report.
The members are as contained in the European Patent Office EDP file on
The European Patent Office is in no way liable for these particulars which are merely given for the purpose of information.

15-08-2023

| Patent document cited in search report | | Publication date | Patent family member(s) | | Publication date |
|---|---|---|---|---|---|
| US 2020288577 | A1 | 10-09-2020 | JP | 7171059 B2 | 15-11-2022 |
| | | | JP | WO2019102701 A1 | 03-12-2020 |
| | | | US | 2020288577 A1 | 10-09-2020 |
| | | | WO | 2019102701 A1 | 31-05-2019 |
| US 2018007800 | A1 | 04-01-2018 | CN | 107211540 A | 26-09-2017 |
| | | | JP | 2016072419 A | 09-05-2016 |
| | | | KR | 20170063844 A | 08-06-2017 |
| | | | US | 2018007800 A1 | 04-01-2018 |
| | | | WO | 2016051273 A1 | 07-04-2016 |

EPO FORM P0459

For more details about this annex : see Official Journal of the European Patent Office, No. 12/82

**EP 4 250 880 A1**

## REFERENCES CITED IN THE DESCRIPTION

### Patent documents cited in the description

- JP 2021055174 A